# EUROPÄISCHE PATENTSCHRIFT

(11) **EP 1 454 193 B1**
(45) Veröffentlichungstag und Bekanntmachung des Hinweises auf die Patenterteilung: **10.10.2007**
(21) Anmeldenummer: 02805247.0
(22) Anmeldetag: 25.11.2002
(51) Int. Cl.: G03F 1/00

(54) **Verfahren zur Herstellung einer Phasenschiebermaske und Verfahren zur Belichtung eines Halbleiterwafers mit solch einer Phasenschiebermaske**
Method of manufacturing a phase shifting mask and wafer exposure method using such a phase shifting mask
Procédé de fabrication d'un masque à décalage de phase et méthode d'exposition d'une tranche semi-conductrice à l'aide d'un tel masque

(30) Priorität: 11.12.2001 DE 10160616
(43) Veröffentlichungstag der Anmeldung: 08.09.2004
(73) Patentinhaber: Infineon Technologies AG, 81669 München (DE)
(72) Erfinder: HENNIG, Mario, 01109 Dresden (DE); KÖHLE, Roderick, 85521 Ottobrunn (DE); KUNKEL, Gerhard, 01445 Radebeul (DE); PFORR, Rainer, 01108 Dresden (DE); VOIGT, Ina, 81369 München (DE)
(74) Vertreter: Epping - Hermann - Fischer
(86) Internationale Anmeldenummer: PCT/DE2002/004321
(87) Internationale Veröffentlichungsnummer: WO 2003/054627

(56) Entgegenhaltungen:
- EP-A- 0 432 900
- US-A- 5 783 336
- US-A- 5 994 002
- US-A- 6 165 692

## Beschreibung

Die vorliegende Erfindung betrifft eine Phasenschiebermaske zur Abbildung wenigstens einer ersten und zweiten transparenten Struktur mittels eines Belichtungsapparates auf einen Halbleiterwafer für die Definition von Grabenkondensatoren in einem Speicherzellenfeld, wobei die erste und zweite Struktur als Paar auf einem Quarzträgermaterial mit einer die erste und zweite Struktur umgebenden lichtundurchlässigen Chromschicht um eine Symmetrieachse angeordnet sind. Die vorliegende Erfindung betrifft ferner ein Verfahren zur Herstellung der Phasenschiebermaske sowie ein Verfahren zur Belichtung eines Halbleiterwafers mit der Phasenschiebermaske. Desweiteren betrifft sie die Verwendung der Phasenschiebermaske zur Herstellung eines Grabenkondensators auf dem Halbleiterwafer.

Um die sich gegenwärtig immer weiter verkleinernden minimalen Strukturbreiten auf Halbleiterwafern herstellen zu können, werden in immer stärkerem Maße Phasenmasken, genauer Phasenschiebermasken, zur optischen Abbildung zumeist im ultravioletten oder Deep-UV Wellenlängenbereich von Strukturen auf die Halbleiterwafer eingesetzt. Ein derartiges Beispiel, bei welchem sehr kleine Strukturabmessungen und damit hohe Pakkungsdichten zu erreichen sind, stellen Maskenebenen zur Herstellung von Grabenkondensatoren (englisch: deep trenches) für Speicherbausteine wie etwa DRAM dar. In einem eine Vielzahl von Grabenkondensatoren umfassenden Speicherzellenfeld werden diese Grabenkondensatoren üblicherweise als periodisch angeordnete Doppel-Langlöcher ausgebildet, d.h. sie bilden Paare von rechteckförmigen Strukturen, wobei die beiden Strukturen eines Paares einen minimalen gegenseitigen Abstand und eine gemeinsame Symmetrieachse in dem diesen Abstand bildenden Zwischenraum besitzen.

Bei dicht aneinanderliegenden symmetrischen Strukturen tritt nun das Problem auf, daß insbesondere bei Verwendung von Halbtonphasenmasken (englisch: attenuated phase-shift masks) und der Anwendung von annularer Beleuchtung Abbildungsfehler des Linsensystems die Abbildungsqualität beeinträchtigen. Die Off-Axis-Beleuchtungstechnik als sogenannte Litho-Enhancement-Technique wird benutzt, um eine hohe Auflösung dieser Strukturen zu erreichen. Dabei wird die Illuminatorquelle als schmaler Ring ausgebildet und die Ringbreite gegenüber dem Ringdurchmesser sehr klein gewählt. Dies ermöglicht eine große Schärfentiefe für die Strukturabbildung. Gerade bei diesen Techniken wird der Einfluß spezieller Linsenaberrationen besonders groß, welches sich bei symmetrischen Strukturen wie im Beispiel der Grabenkondensatorpaare durch unterschiedliche Struktur- oder Linienbreiten einer jeweils rechten Struktur des Paares im Vergleich zur entsprechenden linken Struktur eines Paares erkennbar macht.

Dabei sind die Aberrationskomponenten der Dreiwelligkeit (englisch: three-leaf-clover) und Coma-Verzeichnungen besonders störend. Diese bewirken nicht nur Schwankungen der Strukturbreite nahe aneinander liegender Strukturen sondern auch eine laterale Verschiebung derselben. Die Abbildungsfehler variieren für ein gegebenes Linsensystem über das Bildfeld auf dem Wafer. Zudem unterscheiden sich auch die Aberrationen von Linsensystem zu Linsensystem in den Belichtungsgeräten einer Halbleiterfertigung.

Die Struktur- oder Linienbreiten-Unterschiede zwischen der jeweils rechten und linken Struktur eines Grabenkondensatorpaares wirken sich infolge des Einflusses auf die nachfolgenden Prozesse möglicherweise derart nachteilhaft aus, daß eine einwandfreie Funktion der Schaltkreise nicht mehr gewährleistet ist. Dies betrifft sowohl die Lagegenauigkeit der einzelnen Grabenkondensatoren wie auch Größe und Umfang der Kondensatoren selber.

Ein bisheriger Lösungsansatz basiert darauf, durch eine geeignete Linienbreitenvorkorrektur eines der beiden oder sogar beider Grabenkondensatoren eines Paares die Verteilung der Linienbreiten-Unterschiede über das Bildfeld so zu beeinflussen, daß der Betrag der maximal bei der Abbildung über das Bildfeld auftretenden Unterschiede zwischen der rechten und linken Struktur des Paares minimiert wird. Dazu können für ein Linsensystem mit aus Tests oder Simulationen bekannter Aberrationskarte über das Bildfeld die notwendigen Korrekturen im Maskenlayout derart vorgenommen werden, daß eine beispielsweise durch Aberration verkleinert abgebildete linke Struktur im Layout durch eine entsprechende Vergrößerung der Struktur vorkorrigiert wird, ein sogenanntes selektives Biasing.

Elektronenstrahlschreiber - aber auch Laserschreiber - zur Belichtung der Maskenstrukturen verwenden typischerweise ein Schreibgitter, mit dem Veränderungen der Linienbreiten im Layout durchgeführt werden können. Diese Schreibgeräte arbeiten bei festen Frequenzen, mit denen die einzelnen Adreßpunkte in dem Gitter abgerastert werden. Ein feineres Schreibgitter führt demzufolge zu einer längeren Schreibzeit. Wegen der daraus resultierenden drastischen Vergrößerung der Belichtungszeit beim Maskenschreiben können demnach die Linienbreitenkorrekturen nicht beliebig verkleinert vorgenommen werden. Ein typisches Designgitter beträgt gegenwärtig 5 nm, so daß Strukturen in Inkrementen von 10 nm im Layout verändert werden können.

Auf nachteilhafte Weise vergrößert ein nicht-linearer Faktor zusätzlich bei nahe an der Auflösungsgrenze des optichen Abbildungssystems liegenden Maskenstrukturgrößen die effektiv auf dem Wafer abgebildete Linienbreite. Dieser Mask-Error-Enhancement-Faktor genannte Wert kann für die hier verwendeten Grabenkondensatordimensionen Werte größer als 4 betragen. Um die erforderliche Linienbreitenanpassungen vorzunehmen, müßte man in Inkrementen von mindestens 2,5 nm oder sogar 1,25 nm im Schreibgitter zeichnen. Diese Werte entsprechen allerdings einer Vervierfachung oder Versechzehnfachung der Maskenschreibzeiten mit der Folge einer entsprechenden Kostenvergrößerung. Bei längeren Schreibzeiten entsteht zudem das Problem, daß durch veränderte Reinraumbedingungen, etwa Schwankungen der Temperatur, der Lagefehler der Maskenstrukturen zusätzlich vergrößert wird.

Eine andere Lösung besteht in einer Vergrößerung des Quotienten aus Ringbreite und Ringdurchmesser bei der Off-Axis-Beleuchtungstechnik. Hierdurch kann eine moderate Reduzierung des Linienbreitenunterschiedes erreicht werden, allerdings verliert man deutlich bei der Schärfentiefe der Abbildung. Dadurch erhöht sich die lithografische Reworkrate und es entsteht gleichfalls eine Kostenerhöhung.

In den Druckschriften US 5,783,336 A und EP 0 432 900 A2 sind jeweils Phasenmasken beschrieben, bei denen paarweise auf der Maske angeordnete transparente Strukturen einen Phasenunterschied von 180 Grad zueinander aufzeigen.

Es ist die Aufgabe der vorliegenden Erfindung, die Linienbreitenunterschiede nahe beieinander liegender Strukturen, wie etwa Grabenkondensatorpaare, bei der Abbildung von einer Maske auf einen Wafer zu reduzieren, ohne daß umfangreiche zusätzliche Kosten entstehen.

Die Aufgabe wird gelöst durch ein Verfahren zur Herstellung einer Phasenschiebermaske mit den Merkmalen gemäß Anspruch 1.

Die Aufgabe wird ferner gelöst jeweils durch ein Verfahren zur Belichtung eines Halbleiterwafers mit einer solchen Phasenschiebermaske nach den Ansprüchen 4, 5 oder 7.

Weitere Ausgestaltungen der vorliegenden Erfindung sind den untergeordneten Ansprüchen zu entnehmen.

Die Phasenschiebermaske dient zur Abbildung wenigstens einer ersten und zweiten Struktur mittels eines Belichtungsapparates auf einen Halbleiterwafer für die Definition von Grabenkondensatoren in einem Speicherzellenfeld, wobei die erste und zweite Struktur als Paar auf einem Quarzträgermaterial mit einer die erste und zweite Struktur umgebenden lichtundurchlässigen Chromschicht um eine Symmetrieachse angeordnet sind. Die erste Struktur des Paares weist einen um 180° gegenüber der zweiten Struktur des Paares unterschiedlichen Phasenhub für ein durch diese Strukturen hindurchtretendes Licht auf.

Der vorliegenden Erfindung liegt das Prinzip der sogenannten alternierenden Phasenmasken zugrunde. Bei alternierenden Phasenmasken wird die Phase der Hellgebiete, d.h. der transparenten Strukturen, zum Beispiel durch Ätzung des Glassubstrats - in der Regel Quarzmaterial - derart verändert, daß jeweils benachbarte Hellgebiete, welche durch schmale Chromstrukturen voneinander getrennt sind, bei Lichtdurchfluß einen Phasenhubunterschied von etwa 180° erfahren. Es wird also in dem Paar von Grabenkondensatorstrukturen eine erste oder alle beide Strukturen derart geätzt, daß ein Phasenunterschied von im wesentlichen 180° entsteht. Der Erfindung zufolge erfolgt die Zuordnung der Phasen zu den Strukturen so, daß gerade die mit der größeren Linienbreite auf dem Halbleiterwafer abgebildete Struktur mit dem größeren Phasenhub, d.h. einer größeren Ätzung beaufschlagt wird.

Eine entsprechende Glassubstratätzung wird hier also tiefer ausgebildet. Aufgrund der bei der Maskenherstellung nicht vermeidbaren Toleranzen und infolgedessen auftretender Transmissionsfehler erhält man für diesen Fall die geringsten über das Bildfeld auftretenden Linienbreitenunterschiede für die Strukturen des Grabenkondensatorpaares.

Eine weitere Möglichkeit besteht darin, daß eine Glassubstratätzung in beiden Strukturen des Grabenkondensatorpaares durchgeführt wird, wobei jedoch immer ein Phasenhubunterschied von etwa 180° eingehalten werden muß. Die erfindungsgemäße Bandbreite möglicher Phasenhubunterschiede um den Wert von 180° ist vergleichsweise schmal, um gerade noch die erfindungsgemäße Wirkung zu erzielen. Sie liegt in etwa zwischen 175° und 185°.

Da die Aberrationsfunktion über das Bildfeld eine kontinuierliche Funktion ist, werden sich die beschriebenen Aberrationseffekte über benachbarte Grabenkondensatorpaare in ähnlicher Weise auswirken. Es ist daher besonders vorteilhaft, über ganze Zellbereiche des Zellenfeldes - etwa Spalten oder Zeilen - dieselbe Phasenzuordnung für die rechten beziehungsweise linken Strukturen eines Grabenkondensatorpaares vorzunehmen. Da die Zuordnung der Phase zu den Strukturen - immer bezogen auf die Phase ohne Glasätzung beziehungsweise ohne Beschichtung mit einem phasenschiebenden Material - ein wesentlicher Ausgestaltungsteil der vorliegenden Erfindung darstellt, steht die erfindungsgemäße Phasenmaske in einem engen Zusammenhang mit dem für die Herstellung des Halbleiterwafers verwendeten Linsensystem beziehungsweise dem Belichtungsgerät.

In Abhängigkeit von der für ein spezielles Gerät ermittelten Aberration, d.h. der Frage, ob und wieviel die rechte beziehungsweise linke Struktur gegenüber der jeweils anderen Struktur des Grabenkondensators vergrößert ist, wird die Phasenzuordnung zu den Strukturen vorgenommen. Es ist also durch Tests oder durch eine numerische Simulation für das betreffende Linsensystem das Vorzeichen des Wertes der Linienbreitendifferenz für die Grabenkondensatorpaare festzustellen und die Phasenzuordnung festzulegen.

Vorzugsweise werden für ein spezielles Gerät die über das Bildfeld variienden Linienbreitenunterschiede zwischen einer rechten und linken Struktur zwar einzeln oder wenigstens strichprobenartig gemessen, schließlich jedoch zu einem für das Gerät gültigen mittleren Linienbreitenunterschied zusammengerechnet, welcher dann zu einer globalen Phasenzuordnungimmer der gleichen Struktur innerhalb eines Paares - jeweils entweder der rechten oder linken Struktur - für alle Paare auf der Maske führt. Es ist jedoch gemäß der Erfindung auch denkbar, die Phasenhubzuordnung ortsabhängig, d.h. indviduell für jedes Paar durchzuführen. Bei einem Scanner als Belichtungsgerät für einen Wafer könnten zunächst von links nach rechts entlang des Belichtungsspaltes die Linienbreitendifferenzen auf dem Wafer bestimmt werden. Links eines Nulldurchgangs dieser Differenzen könnten dann beispielsweise auf der Maske jeweils die rechten Strukturen eines Grabenkondensatorpaares mit einem Phasenhub versehen werden, während auf der rechten Seite der dem Nulldurchgang auf dem Wafer entsprechenden Linie auf der Maske die jeweils linken Strukturen einen Phasenhub aufweisen.

Erfindungsgemäß wird also entweder der ersten oder der zweiten Struktur ein Phasenhub zugeordnet. Im nächsten Schritt wird im Zuge der Maskenherstellung der entsprechende Ätzschritt vorgenommen. Beispielsweise kann in dem entsprechenden Maskenlevel der alternierenden Phasenmaske mit dem Maskenschreiber eine entsprechende Glassubstratätzmaske zur Beaufschlagung aller in dem Ermittelungsschritt festgestellten Strukturen innerhalb der Grabenkondensatorpaare mit einem Phasenhub von 180° gezeichnet werden.

Der entscheidende Vorteil der Erfindung besteht darin, daß unter Beibehaltung des lithografischen Prozeßfensters der Einzelstruktur eine signifikante Reduzierung der Linienbreitenschwankungen innerhalb des Bildfeldes erreicht wird, d.h. eine Verbesserung der Gleichmäßigkeit (Uniformity). Das lithografische Overall-Prozeßfenster wird ebenfalls deutlich vergrößert. Infolgedessen reduziert sich die lithografische Reworkrate und die Gutausbeute vergrößert sich. Darüber hinaus reduzieren sich - bedingt durch die gleichzeitige Verringerung der Platzierungsfehler der Strukturen bei der Abbildung auf das Halbleitersubstrat infolge der erfindungsgemäßen Lösung - die Strukturlagefehler über das Bildfeld. Auch hierdurch wird ein Beitrag zur Steigerung der Gutausbeute geleistet.

Als weiterer Vorteil verringert sich - bedingt durch das wesentlich intensivere Luftbild auf dem Halbleiterwafer - die Belichtungszeit auf etwa die Hälfte der konventionell aufgewendeten Zeit für die Belichtung. Daraus ergibt sich eine deutlich verbesserte Produktivität der Belichtungsapparate.

Ein weiterer Vorteil entsteht, wenn erfindungsgemäß für den Füllfaktor bei der Belichtung ein Wert von 0,45 oder größer verwendet wird. Dabei wird der Linienbreitenunterschied deutlich verringert und gleichzeitig ein der Standardtechnologie korrespondierendes Prozeßfenster für die Einzelstruktur erzielt. Das Overall-Prozeßfenster wird dabei sogar vergrößert. Üblicherweise verwendet man bei der Abbildung von alternierenden Phasenmasken einen Füllfaktor von 0,30.

Ein weiterer Vorteil entsteht, wenn bei der Abbildung einer erfindungsgemäßen alternierenden Phasenmaske für in Paaren angeordneten Grabenkondensatorstrukturen anstatt der üblichen zirkularen Lichtquelle eine rechteckige Verteilung der Quelle verwendet wird. Dabei ist die längere Kante der Quelle parallel zur Spiegelachse der Doppelstruktur auf der Maske ausgebildet. Die Verwendung dieser Quelle ermöglicht eine Verbesserung des Prozessfensters für die Länge der Grabenstrukturen und führt somit zu einer reproduzierbaren Längendimension im Fertigungsprozeß. Typische Werte für den korrespondierenden Füllfaktor sind für die Quellenbreite 0,2 bis 0,4 und für die Länge der Quelle 0,4 bis 0,8.

Ein ähnlicher Fall tritt auch ein, wenn die oben genannte rechteckige Quellenverteilung durch Abblenden des mittigen Bereiches in eine Zweipolverteilung verwandelt wird. Typische Werte für den Füllfaktor σ des abgeblendeten Bereiches liegen zwischen 0,2 und 0,4.

Die Erfindung wird im folgenden in Ausführungsbeispielen anhand von Figuren näher erläutert. Darin zeigen:
- Figur 1: eine Anordnung von Strukturen zur Bildung eines Grabenkondensatorpaares auf einer konventionellen Halbtonphasenmaske (a), sowie ein Konturbild der auf dem Halbleiterwafer entstehenden Lackstrukturen (b),
- Figur 2: das erfindungsgemäße Beispiel einer alternierenden Phasenmaske zur Bildung einem Grabenkondensatorpaares mit einem Phasenunterschied (a), sowie dessen Abbild als Konturlinienplot auf einem Halbleiterwafer (b),
- Figur 3: das Prozeßfenster bestehend aus Dosis- und Tiefenschärfe für eine konventionelle Halbtonphasenmaske (2/3 annular) sowie eine erfindungsgemäße alternierende Phasenmaske (0,5 σ),
- Figur 4: zwei Diagramme für eine entgegengesetzte, erfindungsgemäße Phasenhubzuordnung mit der Darstellung des Linienbreitenunterschieds als Funktion der Bildposition für ein Grabenkondensatorpaar,
- Figur 5: verschiedene Ausführungsformen der Verteilung einer Strahlungsquelle für das Verfahren zur Herstellung einer Phasenmaske gemäß dem Stand der Technik (a) und für zwei erfindungsgemäße Beispiele (b), (c) sowie dazu die relative Anordnung von Paaren von Grabenkondensatoren bei einer Belichtung.

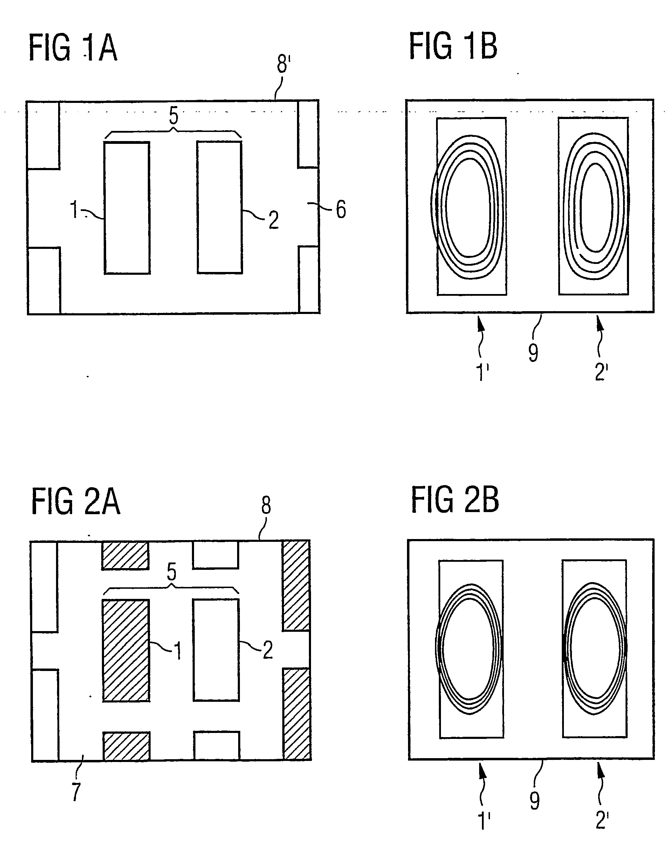

In Figur 1a ist gemäß dem Stand der Technik eine erste Struktur 1 und eine zweite Struktur 2 eines Grabenkondensatorpaares 5 in einem Ausschnitt eines Speicherzellenfeldes auf einer Halbtonphasenmaske 8' dargestellt. In den Bildecken von Figur 1a sind bereits die jeweils rechten beziehungsweise linken Strukturen benachbarter Grabenkondensatorpaare, wie sie üblicherweise in einem Speicherzellenfeld angeordnet sind, dargestellt. Die beiden Strukturen des Grabenkondensatorpaares sind als Hellstrukturen transparent ausgeführt - umgeben von einer semitransparenten Schicht, bestehend aus Molybdän-Silizid 6 mit einer Transmission von 5,5 %. Für die Abbildung dieser Strukturen wurde 2/3 annulare Beleuchtung vorausgesetzt.

In Figur 1b ist in einem Konturplot die zugehörige Lackstruktur auf einem Halbleitersubstrat 9 zu sehen für den Fall, daß objektivtypische Aberrationen vorliegen. Einerseits ist in den abgebildeten Strukturen des Grabenkondensatorpaares 5 auf dem Halbleitersubstrat 9 deutlich eine Rechts-Links-Linienbreitendifferenz zu erkennen, andererseits tritt auch eine asymmetrische Dezentrierung der beiden Strukturen 1, 2 merkbar hervor. Der Linienbreitenunterschied der Grabenkondensatoren beträgt 14 nm. Der linke Grabenkondensator 1 ist 6 nm, der rechte Grabenkondensator 2 ist 7 nm gegenüber dem Schwerpunkt der entsprechenden Maskenstruktur 1, 2 versetzt. Als Rechtecke sind in Figur 1b die Strukturdimensionen der Maske - verkleinert auf den Wafermaßstab - eingezeichnet.

Figur 2a zeigt das Layout einer erfindungsgemäßen alternierenden Phasenmaske 8, und Figur 2b die Kontur der nach der Strukturierung entstehenden Lackstruktur. Die Beleuchtung wurde mit einem Füllfaktor σ = 0,50 ausgeführt, wobei das gleiche Linsensystem wie in Figur 1 verwendet wurde. Gemäß der Erfindung wurde diejenige Struktur des Paares mit einem Phasenhub beaufschlagt, welche durch die Linsenaberrationen vergrößert abgebildet wird im Vergleich zur jeweils anderen Struktur. Nach Figur 1b galt dies für die linke Struktur 1 auf der Maske bzw. die linke Struktur 1' auf dem Halbleiterwafer. Es ist zu beachten, daß in den Figuren die Orientierung des Waferbildes auf die Orientierung des Layouts auf der Maske bezogen ist. Tatsächlich findet bei der Abbildung auf den Wafer im Strahlengang eine Spiegelung statt. In Figur 2 ist der zugeordnete Phasenhub von 180° durch Schraffierung gekennzeichnet.

Da die Aberrationen auf einem kleinen Bildbereich nahezu gleich wirken, werden alle linken Strukturen 1 in diesem Beispiel - also die ganzen Spalten von linken Strukturen - mit dem Phasenhub versehen, d.h. der Glasträger wird geätzt.

Deutlich ist die Reduzierung der Linienbreitenunterschiede der abgebildeten Strukturen 1', 2' auf dem Halbleiterwafer 9 in Figur 2b zu erkennen. Er beträgt bei gleichen Strukturdimensionen auf den verglichenen Masken 8, 8' nun nur noch 6 nm anstatt 14 nm. Darüber hinaus reduziert sich die Deplazierung des Grabenkondensatorpaares von 7 nm auf 3 nm.

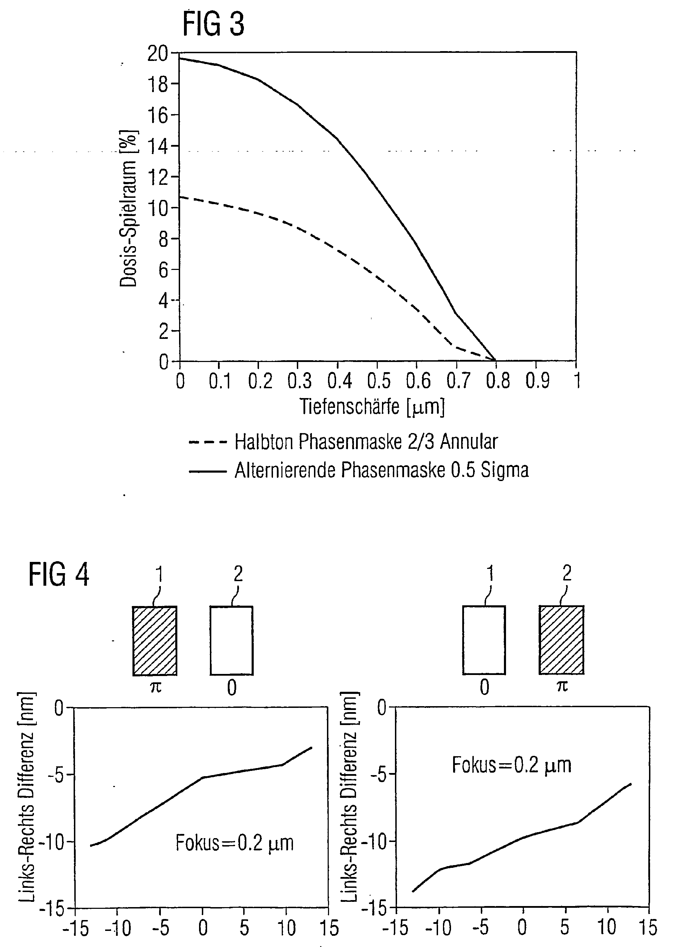

Die Verbesserung des Overall-Prozeßfensters bei Anwendung der erfindungsgemäßen alternierenden Phasenmaske gegenüber der konventionellen Halbtonphasenmaske nach den in den Figuren 1 und 2 gezeigten Beispielen zur Belichtung eines Halbleiterwafers ist in dem Diagramm der Figur 3 zu sehen. Dort ist für verschiedene Tiefenschärfen in Einheiten von µm jeweils der Dosisspielraum für die Belichtung angegeben, für welche gerade noch eine befriedigende Auflösung erreicht wird. Die Halbtonphasenmaske ist strichliniert, die alternierende Phasenmaske durchgezogen dargestellt. Die Größe des Prozeßfensters wird durch das erfindungsgemäße Verfahren nahezu verdoppelt.

Figur 4 zeigt den Einfluß der erfindungsgemäßen Wahl der Phasenzuordnung zu entweder der linken oder rechten Struktur entsprechend dem Beispiel aus Figur 2. Hier wurde für alle Grabenkondensatorpaare 5 auf der Maske im linken Diagramm der Linienbreitenunterschied basierend auf einer Phasenzuordnung zu der linken Struktur 1, und im rechten Diagramm der Linienbreitenunterschied basierend auf einer Phasenzuordnung zu der rechten Struktur 2 als Funktion der Bildposition bei der alternierenden Phasenmaske 8 gemessen. Die Zuordnung zu der durch Aberrationen sonst ohne Phasenzuordnung vergrößerten linken Struktur 1' bewirkt vorteilhaft eine Reduktion der Linienbreitenunterschiede. Die entgegengesetzte Phasenzuordnung zur rechten Struktur 2' bewirkt zwar immer noch eine Verbesserung gegenüber dem Fall der Verwendung einer Halbtonphasenmaske (im ganzen Bildfeld weniger als 14 nm Unterschied), findet jedoch im vorliegenden Vergleich der Phasenzuordnung ein eher schlechteres Ergebnis.

Das Meßergebnis nach Figur 4, durch Simulation oder Fertigungstest bestimmt, kann im erfindungsgemäßen Verfahren als Input für eine Phasenzuordnung zu entweder der linken oder rechten Struktur nahe aneinanderliegender Paare verwendet werden.

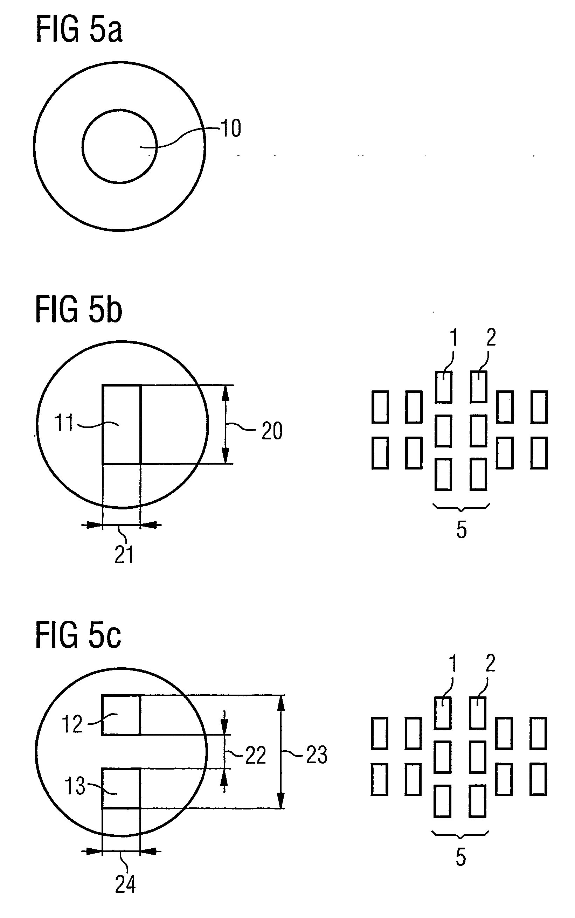

Figur 5 zeigt neben einer konventionellen zirkularen 10 eine dipolartige 24 und rechteckförmige 21 Verteilung der Strahlungsquelle beziehungsweise Aperturöffnung im Beleuchtungssystem des Projektionssystems sowie die dazu korrespondierende Anordnung des Grabenkondensatorpaares 5 auf der Maske 8. Man erkennt, daß die Symmetrieachsen, die durch die Schwerpunkte der Dipole 12, 13 und die beiden Maskenstrukturen 1, 2 gebildet werden, senkrecht aufeinander stehen. Dasselbe gilt für die Längsachse 20 der rechteckigen Strahlungsverteilung 21.

### Bezugszeichenliste

- 1: erste Struktur, linke Struktur
- 2: zweite Struktur, rechte Struktur
- 5: Paar von symmetrischen Strukturen, Grabenkondensatorpaar
- 6: phasenschiebende MoSi-Schicht
- 7: lichtundurchlässige Chromschicht
- 8: Phasenmaske, alternierend, erfindungsgemäß
- 8': Phasenmaske, Halbton, nach Stand der Technik
- 9: Halbleiterwafer
- 11: rechteckförmige Aperturöffnung bzw. Strahlungsverteilung
- 12: symmetrische dipolartige Aperturöffnung, obere Öffnung
- 13: symmetrische dipolartige Aperturöffnung, untere Öffnung
- 20: Längsachse, Längskante rechteckförmige Aperturöffnung
- 21: Breite rechteckförmige Aperturöffnung
- 22: Längenausdehnung dipolartige Aperturöffnung
- 23: Abstand dipolartige Öffnungen
- 24: Breite der symmetrische dipolartigen Aperturöffnungen

## Patentansprüche

1. Verfahren zur Herstellung einer Phasenschiebermaske (8) mit einem Glasträgersubstrat und einer auf dem Glasträgersubstrat angeordneten lichtundurchlässigen Chromschicht (7), welche wenigstens eine erste (1) und eine zweite transparente Struktur (2), die als Paar (5) um eine Symmetrieachse angeordnet sind, umgibt, für die Verwendung in einem Belichtungsapparat mit einem Linsensystem, umfassend die Schritte:
- Bereitstellung von Lagekoordinaten der auf der Phasenschiebermaske (8) zu bildenden ersten (1) und zweiten Struktur (2) des Paares (5),
- Bestimmung des auf einem Halbleiterwafer (9) in dem Belichtungsapparat mit diesen Koordinaten korrespondierenden Bildpunktes,
- Bestimmung eines Linienbreitenunterschieds zwischen der ersten (1) und zweiten (2) Struktur des Paares (5), welcher im Falle einer Belichtung aufgrund einer Aberration für das Linsensystem des Belichtungsapparates in dem Bildpunkt auf dem Halbleiterwafer (9) entsteht,
- Zuordnung eines ersten Phasenhubes zu der ersten zu bildenden Struktur (1) und eines um 180° verschiedenen zweiten Phasenhubes zu der zweiten Struktur (2) in Abhängigkeit des bestimmten Linienbreitenunterschiedes,
- Bereitstellung des mit der Chromschicht (7) beschichteten Glasträgersubstrates,
- Bildung der transparenten ersten (1) und zweiten Struktur (2) des Paares (5) in der Chromschicht (7),
- Ätzung des Glasträgersubstrates zur Ausbildung eines Phasenhubes von 180 ° in genau einer der beiden Strukturen (1, 2) und eines weiteren Phasenhubes in die erste (1) und die zweite transparente Struktur (2), so dass die erste transparente Struktur (1) den ersten Phasenhub und die zweite transparente Struktur (2) den zweiten Phasenhub aufweist.

2. Verfahren nach Anspruch 1,
**dadurch gekennzeichnet, dass**
- zur Ermittlung des Linienbreitenunterschiedes ein erster Querschnitt einer Abbildung der ersten Struktur (1) und ein zweiter Querschnitt einer Abbildung der zweiten Struktur des Paares (5) auf dem Halbleiterwafer (9) ermittelt wird,
- der erste Querschnitt der Abbildung der ersten Struktur (1) und der zweite Querschnitt der Abbildung der zweiten Struktur (2) miteinander verglichen werden,
- der erste Phasenhub kleiner als der zweite Phasenhub gebildet wird, wenn der erste Querschnitt geringer als der zweite Querschnitt ist, oder der erste Phasenhub größer als der zweite Phasenhub gebildet wird, wenn der erste Querschnitt größer als der zweite Phasenhub ist.

3. Verfahren nach Anspruch 1,
**dadurch gekennzeichnet, dass**
die Phasenschiebermaske (8) eine Vielzahl von Paaren (5) von Strukturen aufweist, welche alle die gleiche Orientierung auf der Maske (8) besitzen, und für jedes der Vielzahl von Paaren jeweils die erste Struktur (1) mit dem gleichen Phasenhub die gleiche relative Position innerhalb des Paares (5) besitzt.

4. Verfahren zur Belichtung eines Halbleiterwafers (9) mit einer Phasenschiebermaske (8), die nach dem Verfahren gemäß einem der Ansprüche 1 bis 3 zur Verwendung in dem Belichtungsapparat mit dem Linsensystem hergestellt wurde,
**dadurch gekennzeichnet, dass**
für eine Belichtung zur Abbildung des Paares (5) von Strukturen (1, 2) mit unterschiedlichem Phasenhub ein Füllfaktor σ von wenigstens 0,45 für eine kreisförmige Strahlungsverteilung eingestellt wird.

5. Verfahren zur Belichtung eines Halbleiterwafers (9) mit einer Phasenschiebermaske (8), die nach dem Verfahren gemäß einem der Ansprüche 1 bis 3 zur Verwendung in dem Belichtungsapparat mit dem Linsensystem hergestellt wurde,
**dadurch gekennzeichnet, dass**
für eine Belichtung zur Abbildung des Paares (5) von Strukturen (1, 2) mit unterschiedlichem Phasenhub wenigstens eine rechteckförmige Aperturöffnung (11) eingestellt wird, wobei die parallel zur Längsachse der wenigstens einen rechteckförmigen Öffnung (11) verlaufende Symmetrieachse senkrecht zu der Symmetrieachse des Paares (5) von Strukturen (1, 2) angeordnet ist, welche durch die geometrischen Schwerpunkte der beiden Strukturen (1, 2) verläuft.

6. Verfahren nach Anspruch 5,
**dadurch gekennzeichnet, dass**
die rechteckförmige Aperturöffnung (11) eine Längsachse (20) und eine Breite (21) besitzt, wobei
- die Längsachse (20) einen Füllfaktor von mehr als 0,4 und weniger als 0,8 umfaßt, und
- die Breite (21) einen Füllfaktor von mehr als 0,2 und weniger als 0,4 umfaßt.

7. Verfahren zur Belichtung eines Halbleiterwafers (9) mit einer Phasenschiebermaske (8), die nach dem Verfahren gemäß einem der Ansprüche 1 bis 3 zur Verwendung in dem Belichtungsapparat mit dem Linsensystem hergestellt wurde,
**dadurch gekennzeichnet, dass**
für eine Belichtung zur Abbildung des Paares (5) von Strukturen mit unterschiedlichem Phasenhub (1, 2) zwei symmetrische Aperturöffnungen (12, 13) eingestellt werden, wobei die durch die geometrischen Schwerpunkte der beiden Öffnungen (12, 13) verlaufende Symmetrieachse senkrecht zu der Symmetrieachse des Paares (5) von Strukturen (1, 2) angeordnet ist, welche durch die geometrischen Schwerpunkte der beiden Strukturen (1, 2) verläuft.

8. Verfahren nach Anspruch 7,
**dadurch gekennzeichnet, dass**
die symmetrischen Aperturöffnungen (12, 13) eine Gesamtausdehnung (23) einen gegenseitigen Abstand (22) und eine Breite (24) besitzen, wobei
- die Gesamtausdehnung (23) einen Füllfaktor von mehr als 0,4 und weniger als 0,8 umfaßt, und
- der gegenseitige Abstand (22) einen Füllfaktor von mehr als 0,2 und weniger als 0,4 umfaßt, und
- die Breite (24) einen Füllfaktor von mehr als 0,2 und weniger als 0,4 umfaßt.

## Claims

1. Method for producing a phase shifting mask (8) comprising a glass carrier substrate and a light-opaque chromium layer (7), which is arranged on the glass carrier substrate and which surrounds at least one first (1) and one second transparent structure (2) arranged as a pair (5) about an axis of symmetry, for use in an exposure apparatus with a lens system, comprising the following steps:
- provision of position co-ordinates of the first (1) and second structure (2) of the pair (5) that are to be formed on the phase shifting mask (8),
- determination of the pixel corresponding to these co-ordinates on a semiconductor wafer (9) in the exposure apparatus,
- determination of a line width difference between the first (1) and second (2) structures of the pair (5), which difference arises in the case of an exposure on account of an aberration for the lens system of the exposure apparatus in the pixel on the semiconductor wafer (9),
- assignment of a first phase deviation to the first structure (1) to be formed, and of a second phase deviation - which is different by 180° - to the second structure (2), in a manner dependent on the specific line width difference,
- provision of the glass carrier substrate coated with the chromium layer (7),
- formation of the transparent first (1) and second structure (2) of the pair (5) in the chromium layer (7),
- etching of the glass carrier substrate in order to form a phase deviation of 180° in precisely one of the two structures (1, 2) and a further phase deviation into the first (1) and the second transparent structure (2), so that the first transparent structure (1) has the first phase deviation and the second transparent structure (2) has the second phase deviation.

2. Method according to Claim 1,
**characterized in that**
- in order to determine the line width difference, a first cross section of an imaging of the first structure (1) and a second cross section of an imaging of the second structure of the pair (5) on the semiconductor wafer (9) are determined,
- the first cross section of the imaging of the first structure (1) and the second cross section of the imaging of the second structure (2) are compared with one another,
- the first phase deviation is formed such that it is less than the second phase deviation if the first cross section is smaller than the second cross section, or the first phase deviation is formed to be greater than the second phase deviation if the first cross section is larger than the second phase deviation.

3. Method according to Claim 1,
**characterized in that**
the phase shifting mask (8) has a multiplicity of pairs (5) of structures which all have the same orientation on the mask (8), and, for each of the multiplicity of pairs, in each case the first structure (1) with the same phase deviation has the same relative position within the pair (5).

4. Method for exposing a semiconductor wafer (9) with a phase shifting mask (8) which has been produced according to the method according to one of Claims 1 to 3 for use in the exposure apparatus with the lens system,
**characterized in that**
a filling factor σ of at least 0.45 for a circular radiation distribution is set for an exposure for imaging the pair (5) of structures (1, 2) with a different phase deviation.

5. Method for exposing a semiconductor wafer (9) with a phase shifting mask (8) which has been produced according to the method according to one of Claims 1 to 3 for use in the exposure apparatus with the lens system,
**characterized in that**
at least one rectangular aperture opening (11) is set for an exposure for imaging the pair (5) of structures (1, 2) with a different phase deviation, the axis of symmetry which runs parallel to the longitudinal axis of the at least one rectangular opening (11) being arranged perpendicular to the axis of symmetry of the pair (5) of structures (1, 2), which runs through the geometrical centroids of the two structures (1, 2).

6. Method according to Claim 5,
**characterized in that**
the rectangular aperture opening (11) has a longitudinal axis (20) and a width (21),
- the longitudinal axis (20) comprising a filling factor of more than 0.4 and less than 0.8, and
- the width (21) comprising a filling factor of more than 0.2 and less than 0.4.

7. Method for exposing a semiconductor wafer (9) with a phase shifting mask (8) which has been produced according to the method according to one of Claims 1 to 3 for use in the exposure apparatus with the lens system,
**characterized in that**
two symmetrical aperture openings (12, 13) are set for an exposure for imaging the pair (5) of structures with a different phase deviation (1, 2), the axis of symmetry which runs through the geometrical centroids of the two openings (12, 13) being arranged perpendicular to the axis of symmetry of the pair (5) of structures (1, 2), which runs through the geometrical centroids of the two structures (1, 2).

8. Method according to Claim 7,
**characterized in that**
the symmetrical aperture openings (12, 13) have a total extent (23), a mutual distance (22) and a width (24),
- the total extent (23) comprising a filling factor of more than 0.4 and less than 0.8, and
- the mutual distance (22) comprising a filling factor of more than 0.2 and less than 0.4, and
- the width (24) comprising a filling factor of more than 0.2 and less than 0.4.

## Revendications

1. Procédé de fabrication d'un masque (8) à décalage de phase comprenant un substrat support en verre et une couche (7) de chrome opaque disposée sur le substrat support en verre et entourant au moins une première (1) et une deuxième (2) structures transparentes qui sont déposées sous la forme d'une paire (5) autour d'un axe de symétrie pour l'utilisation dans un appareil d'insolation ayant un système de lentilles, comprenant les stades :
- on met à disposition des coordonnées de position de la première (1) et de la deuxième (2) structures de la paire (5) à former sur le masque (8) à décalage de phase,
- on détermine le point image correspondant à ces coordonnées sur une tranche (9) de semi-conducteur dans l'appareil d'insolation,
- on détermine une différence de largeur de trait entre la première (1) et la deuxième (2) structures de la paire (5) qui se crée au point image sur la tranche (9) de semi-conducteur dans le cas d'une insolation en raison d'une aberration pour le système de lentilles de l'appareil d'insolation,
- on associe un premier écart de phase à la première structure (1) à former et un deuxième écart de phase différent de 180° à la deuxième structure (2) en fonction de la différence de largeur de trait déterminée,
- on met à disposition le substrat support en verre revêtu de la couche (7) de chrome,
- on forme la première (1) et la deuxième (2) structures transparentes de la paire (5) dans la couche (7) de chrome,
- on attaque le substrat support en verre pour former un écart de phase de 180° dans exactement l'une des deux structures (1, 2) et un autre écart de phase dans les première (1) et deuxième (2) structures transparentes, de façon à ce que la première structure (1) transparente ait le premier écart de phase et la deuxième structure (2) transparente le deuxième écart de phase.

2. Procédé suivant la revendication 1,
**caractérisé en ce que**
- pour déterminer la différence de largeur de trait, on détermine une première section transversale d'une reproduction de la première structure (1) et une deuxième section transversale d'une reproduction de la deuxième structure de la paire (5) sur la tranche (9) de semi-conducteur,
- on compare la première section transversale de la reproduction de la première structure (1) et la deuxième section transversale de la reproduction de la deuxième structure (2) entre elles,
- on fait en sorte que le premier écart de phase soit plus petit que le deuxième écart de phase si la première section transversale est plus petite que la deuxième section transversale, ou on fait en sorte que le premier écart de phase soit plus grand que le deuxième écart de phase si la première section transversale est plus grande que la deuxième écart de phase.

3. Procédé suivant la revendication 1,
**caractérisé en ce que**
le masque (8) à décalage de phase a une pluralité de paires (5) de structures qui ont toutes la même orientation sur le masque (8) et pour chacune de la pluralité de paires, respectivement, la première structure (1) ayant le premier écart de phase a la même position relative dans la paire (5).

4. Procédé d'insolation d'une tranche (9) de semi-conducteur à l'aide d'un masque (8) à décalage de phase qui a été fabriqué suivant le procédé selon l'une des revendications 1 à 3 pour l'utilisation dans l'appareil d'insolation ayant le système de lentilles,
**caractérisé en ce que**
pour une insolation pour la reproduction de la paire (5) de structures (1, 2) ayant un écart de phase différent, on règle un facteur σ de remplissage de moins de 0,45 pour une répartition circulaire du rayonnement.

5. Procédé d'insolation d'une tranche (9) de semi-conducteur à l'aide d'un masque (8) à décalage de phase qui a été fabriqué suivant le procédé selon l'une des revendications 1 à 3 pour l'utilisation dans l'appareil d'insolation ayant le système de lentilles,
**caractérisé en ce que**
pour une insolation pour la reproduction de la paire (5) de structures (1, 2) ayant un écart de phase différent, on règle au moins une ouverture (11) rectangulaire, l'axe de symétrie s'étendant parallèlement à l'axe longitudinal de la au moins l'ouverture (11) rectangulaire étant perpendiculaire à l'axe de symétrie de la paire (5) de structures (1, 2) qui passe par le centre de gravité géométrique des deux structures (1, 2).

6. Procédé suivant la revendication 5,
**caractérisé en ce que**
l'ouverture (11) rectangulaire a un axe (20) longitudinal et une largeur (21),
- l'axe (20) longitudinal a un facteur de remplissage de plus de 0,4 et de moins de 0,8, et
- la largeur (21) a un facteur de remplissage de plus de 0,2 et de moins de 0,4.

7. Procédé d'insolation d'une tranche (9) de semi-conducteur à l'aide d'un masque (8) à décalage de phase qui a été fabriqué suivant le procédé selon l'une des revendications 1 à 3 pour l'utilisation dans l'appareil d'insolation ayant le système de lentilles,
**caractérisé en ce que**
pour une insolation pour la reproduction de la paire (5) de structures ayant un écart (1, 2) de phase différent, on règle deux ouvertures (12, 13) symétriques, l'axe de symétrie passant par les deux centres de gravité géométriques des deux ouvertures (12, 13) étant perpendiculaire à l'axe de symétrie de la paire (5) de structures (1, 2) qui passe par le centre de gravité géométrique des deux structures (1, 2).

8. Procédé suivant la revendication 7,
**caractérisé en ce que**
les ouvertures (12, 13) symétriques ont une étendue (23) totale, une distance (22) mutuelle et une largeur (24),
- l'étendue (23) totale a un facteur de remplissage de plus de 0,4 et de moins de 0,8, et
- la distance (22) mutuelle a un facteur de remplissage de plus de 0,2 et de moins de 0,4, et
- la largeur (24) a un facteur de remplissage de plus de 0,2 et de moins de 0,4.
